# EUROPEAN PATENT SPECIFICATION

(11) **EP 2 679 706 B1**
(45) Date of publication and mention of the grant of the patent: **31.10.2018**
(21) Application number: 11859432.4
(22) Date of filing: 23.02.2011
(51) Int. Cl.: C30B 13/12, C30B 29/06

(54) **METHOD FOR MANUFACTURING N-TYPE SILICON SINGLE CRYSTAL**
VERFAHREN ZUR HERSTELLUNG EINES N-LEITENDEN SILICIUMEINKRISTALLS
PROCÉDÉ POUR LA FABRICATION DE MONOCRISTAL DE SILICIUM DE TYPE N

(43) Date of publication of application: 01.01.2014
(73) Proprietor: Shin-Etsu Handotai Co., Ltd., Tokyo (JP)
(72) Inventor: KODAMA, Yoshihiro, Jyoetsu-shi Niigata 942-0157 (JP); SATO, Kenichi, Jyoetsu-shi Niigata 942-0157 (JP); NAKAZAWA, Keiichi, Jyoetsu-shi Niigata 942-0157 (JP)
(74) Representative: Wibbelmann, Jobst
(86) International application number: PCT/JP2011/001008
(87) International publication number: WO 2012/114375

(56) References cited:
- EP-A1- 0 054 657
- WO-A1-2006/003782
- CN-A- 1 865 530
- JP-A- 2005 306 653
- JP-A- 2005 306 653
- JP-A- 2006 169 060
- JP-A- 2007 112 640
- JP-A- 2010 215 431
- US-A1- 2001 020 438
- US-A1- 2003 024 469
- US-A1- 2008 029 019
- US-A1- 2009 224 366
- US-A1- 2010 107 968
- US-A1- 2011 030 793
- VON AMMON W ET AL: "The impact of nitrogen on the defect aggregation in silicon", JOURNAL OF CRYSTAL GROWTH, ELSEVIER, AMSTERDAM, NL, vol. 226, no. 1, 1 June 2001 (2001-06-01), pages 19-30, XP004242484, ISSN: 0022-0248, DOI: 10.1016/S0022-0248(01)01277-5
- JONG HOE WANG: 'Resistivity distribution of silicon single crystals using codoping' JOURNAL OF CRYSTAL GROWTH vol. 280, no. 3-4, 2005, pages 408 - 412, XP004929397

## Description

### TECHNICAL FIELD

The present invention relates to single crystal production methods using the FZ method (floating zone method or floating zone melting method) by which a single crystal ingot is grown by forming a floating zone by heating and melting a raw material crystal ingot with an induction heating coil and moving the floating zone and to silicon single crystals and, more particularly, to a single crystal production method that prevents the generation of OSFs (oxidation-induced stacking faults) and a phosphorus-doped N-type silicon single crystal.

### BACKGROUND ART

The FZ method is used as one of methods for producing a semiconductor single crystal, for example, a silicon single crystal that is most commonly used as a semiconductor device at present.

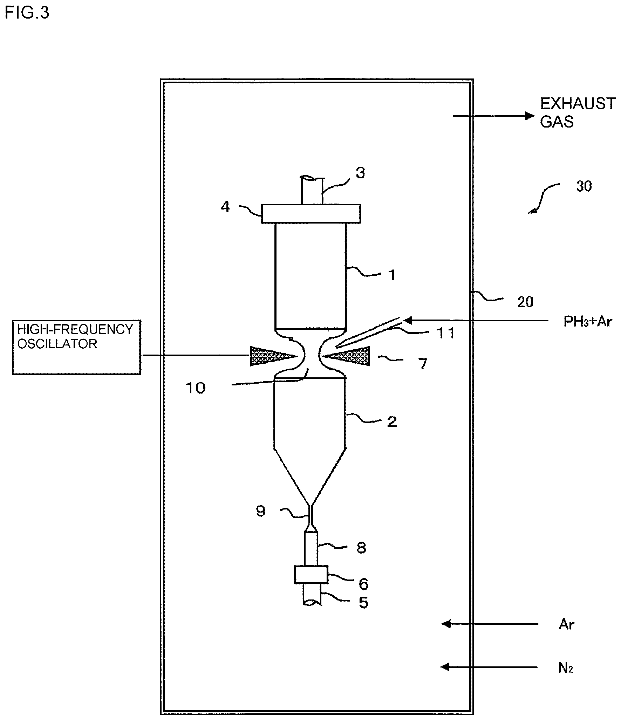

FIG. 3 is an example of a single crystal production apparatus used in an existing FZ single crystal production method. A method for producing a single crystal by using this FZ single crystal production apparatus 30 will be described.

First, a raw material crystal ingot 1 is held by an upper holding jig 4 of an upper shaft 3 placed in a chamber 20. On the other hand, a seed (seed crystal) 8 of a single crystal with a small diameter is held by a lower holding jig 6 of a lower shaft 5 located below the raw material crystal ingot 1.

Next, the raw material crystal ingot 1 is melted by an induction heating coil 7 and is fusion-bonded to the seed crystal 8. Thereafter, a neck portion 9 is formed by necking to eliminate dislocation. Then, by moving the raw material crystal ingot 1 and a grown single crystal ingot 2 downward while rotating the upper shaft 3 and the lower shaft 5, a floating zone (also called a melt zone or molten melt) 10 is formed between the raw material crystal ingot 1 and the grown single crystal ingot 2, the floating zone 10 is moved to an upper end of the raw material crystal ingot 1, and zoning is performed, whereby the grown single crystal ingot 2 is grown.

Incidentally, this single crystal growth is performed in an atmosphere obtained by mixing a very small amount of nitrogen gas into Ar gas, and, in order to produce an N-type FZ single crystal, Ar-based PH₃ gas whose amount is determined based on resistivity to be produced is fed by a nozzle for spraying doping gas (doping nozzle) 11.

As the induction heating coil 7 described above, a single-wound or compound-wound induction heating coil made of copper or silver, the induction heating coil through which cooling water is circulated, is used.

In recent years, the need for a larger-diameter single crystal has intensified. As a result, also in the FZ method, more and more larger-diameter single crystals are being produced. However, if an N-type large-diameter FZ single crystal, in particular, a large-diameter single crystal with a diameter of 200 mm or more is produced by an existing method, when an OSF test (for example, at 1150°C, Wet O₂-100 min, selective etching 4 min) is performed on a wafer cut from this crystal, OSFs are generated, which poses a problem.

As measures to prevent OSFs, in production of a CZ single crystal, a manufacturing method in which doping with Al (aluminum) is performed has been disclosed (refer to, for example, Patent Literature 1). However, in an FZ single crystal which is required to be a crystal with high resistivity as compared to a CZ single crystal, if doping with Al whose segregation coefficient is 0.002 and is lower than 0.35 of P (phosphorus) and 0.8 of B (boron) is performed, the in-plane resistivity distribution and the axial resistivity distribution become substantially worse, making it impossible to control resistivity, and it is difficult to perform gas doping with Al. It is for this reason that an alternative to Al doping has been sought after.

### CITATION LIST

### PATENT LITERATURE

Patent Literature 1: Japanese Unexamined Patent publication (Kokai) No.H8-73293

CN 1 865 530 A discloses a silicon ingot manufactured with the FZ method using PH₃ or B₂H₆ as dopant.

W. von Ammon et al. report about "The impact of nitrogen on the defect aggregation in silicon" in JOURNAL OF CRYSTAL GROWTH, ELSEVIER, AMSTERDAM, NL, vol. 226, no. 1, 1 June 2001. From this document it is known that N₂ has the effect of limiting stacking faults and aggregation defects in silicon single crystal growth by the FZ method.

US 2011/0030793 A1 discloses the production of photovoltaic grade crystalline silicon by crystallization of a molten silicon feedstock.

US 2001/0020438 A1 concerns a method for manufacturing a dislocation-free silicon single crystal. This method includes the steps of preparing a silicon seed crystal formed of a dislocation-free single crystal having a boron concentration of 1x10¹⁸ atoms/cm³ or more.

US 2003/0024469 A1 discloses that a silicon single crystal may be produced by crucible-free float zone pulling, wherein the single crystal has a diameter of at least 200 mm over a length of at least 200 mm and is free of dislocations in the region of this length.

### SUMMARY OF THE INVENTION

The present invention has been made in view of the problems described above and an object thereof is to provide an N-type silicon single crystal production method and an N-type silicon single crystal, the method that can prevent the generation of OSFs even when a silicon single crystal, in particular, a large-diameter silicon single crystal with a diameter of 8 inches (200 mm) or more is produced by the FZ method.

To solve the above-described problems, the present invention provides a method for producing an N-type silicon single crystal with a diameter of 8 inches (200 mm) or more by the FZ method, wherein the N-type silicon single crystal is produced by performing doping by using Ar-based PH₃ gas and Ar-based B₂H₆ gas as doping gas, and by feeding the Ar-based B₂H₆ gas in such a way that a B concentration in the N-type silicon single crystal to be produced becomes 3x10¹² atoms/cm³ or more.

With such a method, it is possible to produce a high-quality N-type FZ silicon single crystal in which OSFs are not generated.

In this case, it is possible that the doping by the Ar-based PH₃ gas and the Ar-based B₂H₆ gas is performed by mixing the Ar-based PH₃ gas and the Ar-based B₂H₆ gas and feeding the mixture of the gases from a nozzle for spraying doping gas, the nozzle provided near molten melt of an FZ single crystal production apparatus, or a doping gas jetting port provided below the molten melt.

As described above, by mixing the Ar-based PH₃ gas and the Ar-based B₂H₆ gas and feeding the mixture from the nozzle for spraying doping gas, it is easy to control the B concentration with which doping is performed and it is possible to make an N-type silicon single crystal to be produced absorb B more easily, and, by mixing the Ar-based PH₃ gas and the Ar-based B₂H₆ gas and feeding the mixture from the doping gas jetting port, it is possible to perform uniform doping with B and P.

Moreover, it is also possible that the doping by the Ar-based PH₃ gas and the Ar-based B₂H₆ gas is performed by feeding the Ar-based PH₃ gas from a nozzle for spraying doping gas, the nozzle provided near molten melt of an FZ single crystal production apparatus, and by feeding the Ar-based B₂H₆ gas from a doping gas jetting port provided below the molten melt.

As described above, by feeding the Ar-based PH₃ gas from the nozzle for spraying doping gas and feeding the Ar-based B₂H₆ gas from the doping gas jetting port, it is possible to adjust easily the resistivity by doping with P that requires a higher concentration than that of B to obtain an N-type crystal and perform uniform doping with B that is performed at a low concentration to prevent the generation of OSFs.

Moreover, it is possible that an N-type silicon single crystal with a diameter of 8 inches (200 mm) or more is produced by feeding the Ar-based B₂H₆ gas in such a way that a B concentration in an N-type silicon single crystal to be produced becomes 3×10¹² atoms/cm³ or more.

With such a B concentration, even when the crystal has a large diameter of 8 inches (200 mm) or more, it is possible to obtain an adequate OSF generation-prevention effect and produce a high-quality single crystal with stability.

Furthermore, the present invention provides a phosphorus-doped N-type FZ silicon single crystal, wherein the phosphorus-doped N-type FZ silicon single crystal has at least a B concentration of 3×10¹² atoms/cm³ or more and a diameter of 8 inches (200 mm) or more.

While such a phosphorus-doped N-type FZ silicon single crystal is an N-type large-diameter FZ silicon single crystal, since the phosphorus-doped N-type FZ silicon single crystal is a high-quality silicon single crystal in which OSFs are not generated, this phosphorus-doped N-type FZ silicon single crystal is highly valuable as a product.

As described above, according to the method for producing an N type FZ silicon single crystal of the present invention, it is possible to produce stably a high-quality single crystal in which OSFs are not generated even when, in particular, the crystal has a large diameter of 8 inches (200 mm) or more.

### BRIEF DESCRIPTION OF THE DRAWINGS

FIG. 1 is a schematic diagram of an example of a single crystal production apparatus using the FZ method used in a method for producing an N-type silicon single crystal of the present invention;
FIG. 2 is a schematic diagram of another example of the single crystal production apparatus using the FZ method used in the method for producing an N-type silicon single crystal of the present invention; and
FIG. 3 is a schematic diagram of an example of a single crystal production apparatus used in an existing FZ single crystal production method.

### BEST MODE FOR CARRYING OUT THE INVENTION

Hereinafter, the present invention will be described more specifically.

As mentioned earlier, as larger-diameter single crystals have been required in recent years, more and more larger-diameter single crystals are being produced by the FZ method. However, if a large-diameter single crystal, in particular, a silicon single crystal with a diameter of 8 inches (200 mm) or more is produced by an existing manufacturing method, OSFs are generated frequently, which poses a problem.

The inventors of the present invention intensively studied the causes of OSFs that are generated when a large-diameter N-type silicon single crystal with a diameter of 6 inches (150 mm) or more, in particular, a diameter of 8 inches (200 mm) or more is produced by the FZ method. As a result, the inventors of the present invention have found out that, when a large-diameter single crystal is produced by the FZ method, a region in which interstitial silicon is predominant is generated on the periphery of the crystal and the interstitial silicon agglomerates together and becomes a nucleus, resulting in the generation of OSFs.

Thus, as a result of the inventors of the present invention focusing attention on the fact that B suppresses the generation of an interstitial silicon type dislocation cluster in the CZ method ("Silicon Technology, No. 59, The Effect of Impurities on the Grown-in Defects in CZ-Si Crystals (B, C, N, O, Sb, As, P) Kozo Nakamura, Junsuke Tomioka") and further having kept conducting experiments and the like, the inventors of the present invention have found out that, in a method for producing an FZ silicon single crystal containing no oxygen, by performing B₂H₆ gas doping along with PH₃ gas doping during zoning to produce an N-type FZ single crystal and adding a very small amount of B to the single crystal, it is possible to suppress the generation of an interstitial silicon type dislocation cluster which can be an OSF nucleus and prevent the generation of OSFs, and have completed the present invention.

Hereinafter, an embodiment of the present invention will be described with reference to the drawings, but the present invention is not limited thereto.

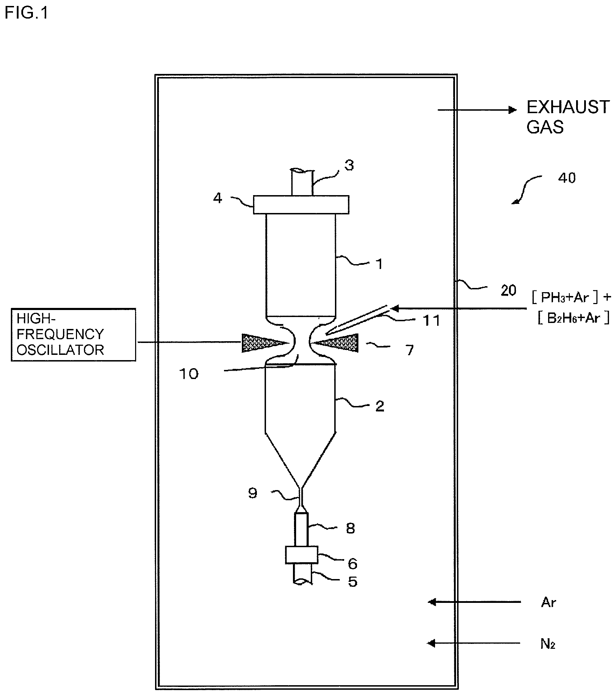

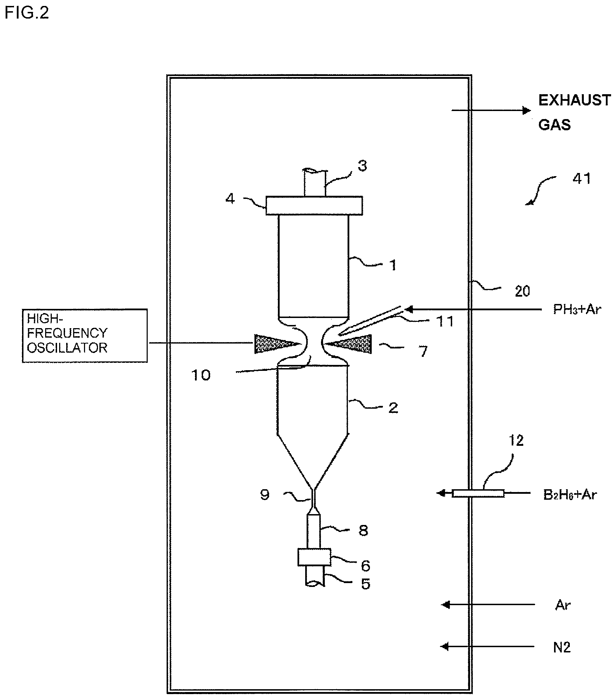

FIGs. 1 and 2 are schematic diagrams of examples of a single crystal production apparatus used in a method for producing an N type FZ silicon single crystal of the present invention.

An FZ single crystal production apparatus 40 of FIG. 1 includes a chamber 20 that houses a raw material crystal ingot 1 and a grown single crystal ingot 2 and an induction heating coil 7 serving as a heat source for forming a floating zone (molten melt) 10 between the raw material crystal ingot 1 and the grown single crystal ingot 2. In addition, from a nozzle for spraying doping gas (doping nozzle) 11, Ar-based PH₃ gas for producing an N-type silicon single crystal and Ar-based B₂H₆ gas for preventing the generation of OSFs are mixed and fed.

In an FZ single crystal production apparatus 41 of FIG. 2, from the doping nozzle 11, Ar-based PH₃ gas for producing an N-type silicon single crystal is fed, and, from a doping gas jetting port 12 located below the molten melt 10, Ar-based B₂H₆ gas for preventing the generation of OSFs is fed. The other configurations are almost the same as those of FIG. 1.

In the present invention, for example, by using such a single crystal production apparatus 40, an N-type silicon single crystal is produced in the following manner.

First, a portion of the silicon raw material ingot 1, the portion from which melting is started, is manufactured into the shape of a cone, and etching is performed on the surface to remove mechanical damage. Then, the silicon raw material ingot 1 is housed in the chamber 20 of the FZ single crystal production apparatus 40 depicted in FIG. 1 and is fixed to an upper holding jig 4 of an upper shaft 3 placed in the chamber 20 with a screw or the like. On the other hand, a seed crystal 8 is attached to a lower holding jig 6 of a lower shaft 5.

Next, a lower end of the cone portion of the silicon raw material ingot 1 is preliminarily heated by a carbon ring (not shown). Then, Ar gas containing nitrogen gas is fed from a lower part of the chamber 20 and the gas is exhausted from an upper part of the chamber to set the pressure at 0.15 MPa, the rate of flow of the Ar gas at 20 to 50 l/min, and the concentration of nitrogen in the chamber at 0.1 to 0.5%, for example. In addition, after heating and melting the silicon raw material ingot 1 by the induction heating coil 7, the tip of the cone portion is fusion-bonded to the seed crystal 8, dislocation is eliminated by a neck portion 9, and by moving the silicon raw material ingot 1 and the grown single crystal ingot 2 downward at a rate of 1 to 5 mm/min, for example, while rotating the upper shaft 3 and the lower shaft 5, the molten melt 10 is moved to an upper end of the silicon raw material ingot 1 and zoning is performed, whereby the silicon single crystal ingot 2 is grown.

At this time, it is preferable that the growth of a single crystal is performed by displacing the upper shaft 3 which becomes a rotation center at the time of the growth of the silicon raw material ingot 1 from the lower shaft 5 which becomes a rotation center of the single crystal at the time of single crystallization (making the upper shaft 3 and the lower shaft 5 eccentric). By displacing one central axis from the other central axis, it is possible to allow a molten portion to be agitated at the time of single crystallization and thereby it is possible to homogenize the quality of a single crystal to be produced. The amount of eccentricity may be set in accordance with the diameter of a single crystal.

Moreover, to obtain predetermined N-type resistivity during zoning, Ar-based PH₃ gas and Ar-based B₂H₆ gas for preventing OSFs are mixed and fed from the doping nozzle 11.

At this time, the concentration of PH₃ in doping gas is set to be higher than the B₂H₆ concentration such that the conductivity type of a silicon single crystal to be obtained becomes N type. The ratio of concentration between PH₃ and B₂H₆ or a concentration difference may be determined such that a silicon single crystal to be produced has required resistivity.

In addition to this, as depicted in FIG. 2, when the single crystal production apparatus 41 described above, for example, is used, the Ar-based B₂H₆ gas may be fed from the doping gas jetting port 12 located below the molten melt, or, for example, the Ar-based PH₃ gas and the Ar-based B₂H₆ gas can also be mixed and fed from the doping gas jetting port 12.

At this time, to produce a large-diameter N-type silicon single crystal with a diameter of 8 inches (200 mm) or more without problems, it is preferable to feed the Ar-based B₂H₆ gas in such a way that the B concentration in an N-type silicon single crystal to be produced becomes 3×10¹² atoms/cm³ or more. Therefore, it is necessary simply to feed Ar-based PH₃ at a concentration at which a B concentration of 3×10¹² atoms/cm³ or more in a silicon single crystal is cancelled out to obtain an N-type silicon single crystal with desired resistivity.

The N-type silicon single crystal produced in this manner contains a B concentration of 3×10¹² atoms/cm³ or more, and, even when the crystal has a large-diameter N-type silicon single crystal with a diameter of 8 inches (200 mm) or more, it is possible to prevent the generation of OSFs. Therefore, the present invention can provide a high-quality phosphorus-doped N-type FZ silicon single crystal.

Incidentally, the upper limit of the B concentration in the N-type silicon single crystal may be adjusted in such a way that the upper limit is up to the solubility limit at which a single crystal structure can be maintained with both P for producing an N-type silicon single crystal and B for preventing OSFs and desired resistivity is obtained at a concentration that is lower than that concentration.

### EXAMPLES

Hereinafter, the present invention will be described more specifically with examples and a comparative example, but the present invention is not limited to these examples.

### (Example 1)

By using a CZ silicon single crystal with a resistivity of 1000 Qcm or more and a diameter of 150 mm as a silicon raw material ingot, zoning was performed by the FZ method, whereby an FZ silicon single crystal with a diameter of 205 mm and a straight body length of 70 cm, the FZ silicon single crystal with a target set at N type and 50 Qcm, was produced.

When this silicon single crystal was produced, the single crystal production apparatus depicted in FIG. 1 was used.

As the induction heating coil, a parallel coil having an internal first heating coil with an outside diameter of 160 mm and an outer second heating coil with an outside diameter of 280 mm was used, the furnace pressure was set at 0.19 MPa, the rate of flow of Ar gas was set at 50 L/min, the concentration of nitrogen gas in the chamber was set at 0.1%, the growth rate was set at 2.0 mm/min, and the amount of eccentricity was set at 12 mm. Moreover, a quartz plate for preventing discharge was inserted into a slit of the induction heating coil.

From the doping nozzle, Ar-based PH₃ gas at a 0.35 to 0.45 ppma concentration was fed at a flow rate of 1000 cc/min and Ar-based B₂H₆ gas at a 0.004 to 0.02 ppma concentration was fed at a flow rate of 500 cc/min.

In this manner, eight silicon single crystals produced by the FZ method were obtained without any trouble without the generation of dislocation during the growth.

As a result of an OSF test (1150°C Wet O₂-100 min, selective etching 4 min) having been performed on the wafers cut from the cone side, the central part, and the tail side of the crystals thus obtained, OSFs were not generated in all of the crystals. Moreover, as a result of measurement of the B concentration in a crystal having being performed on the tail-side samples by the PL method, the B concentration was 4.07×10¹² to 8.15×10¹² atoms/cm³ (samples Nos. 10 to 17 in Table 1). Furthermore, the target resistivity was also obtained.

### (Example 2)

By using a CZ silicon single crystal with a resistivity of 1000 Qcm or more and a diameter of 150 mm as a silicon raw material ingot, zoning was performed by the FZ method, whereby an FZ silicon single crystal with a diameter of 205 mm and a straight body length of 70 cm, the FZ silicon single crystal with a target set at N type and 50 Qcm, was produced.

When this silicon single crystal was produced, the single crystal production apparatus depicted in FIG. 2 was used.

As the induction heating coil, a parallel coil having an internal first heating coil with an outside diameter of 160 mm and an outer second heating coil with an outside diameter of 280 mm was used, the furnace pressure was set at 0.19 MPa, the rate of flow of Ar gas was set at 50 L/min, the concentration of nitrogen gas in the chamber was set at 0.1%, the growth rate was set at 2.0 mm/min, and the amount of eccentricity was set at 12 mm. Moreover, a quartz plate for preventing discharge was inserted into a slit of the induction heating coil.

From the doping nozzle, Ar-based PH₃ gas at a 0.35 to 0.45 ppma concentration was fed at a flow rate of 1000 cc/min and, from the doping gas jetting port located below the molten melt, Ar-based B₂H₆ gas at a 0.002 to 0.06 ppma concentration was fed at a flow rate of 1000 cc/min.

In this manner, ten silicon single crystals produced by the FZ method were obtained without any trouble without the generation of dislocation during the growth.

As a result of an OSF test (1150°C Wet O₂-100 min, selective etching 4 min) having been performed on the wafers cut from the cone side, the central part, and the tail side of the crystals thus obtained, OSFs were not generated in all of the crystals. Moreover, as a result of measurement of the B concentration in a crystal having being performed on the tail-side samples by the PL method, the B concentration was 3.22×10¹² to 8.05×10¹² atoms/cm³ (samples Nos. 18 to 27 in Table 1). Furthermore, the target resistivity was also obtained.

### (Comparative Example)

By using a CZ silicon single crystal with a resistivity of 1000 Ωcm or more and a diameter of 150 mm as a silicon raw material ingot, zoning was performed by the FZ method, whereby an FZ silicon single crystal with a diameter of 205 mm and a straight body length of 70 cm, the FZ silicon single crystal with a target set at N type and 50 Ωcm, was produced.

When this silicon single crystal was produced, the single crystal production apparatus depicted in FIG. 3 was used.

As the induction heating coil, a parallel coil having an internal first heating coil with an outside diameter of 160 mm and an outer second heating coil with an outside diameter of 280 mm was used, the furnace pressure was set at 0.19 MPa, the rate of flow of Ar gas was set at 50 L/min, the concentration of nitrogen gas in the chamber was set at 0.1%, the growth rate was set at 2.0 mm/min, and the amount of eccentricity was set at 12 mm. Moreover, a quartz plate for preventing discharge was inserted into a slit of the induction heating coil.

From the doping nozzle, Ar-based PH₃ gas at a 0.35 to 0.45 ppma concentration was fed at a flow rate of 1000 cc/min.

In this manner, nine silicon single crystals produced by the FZ method were obtained without any trouble without the generation of dislocation during the growth.

As a result of an OSF test (1150°C Wet O₂-100 min, selective etching 4 min) having been performed on the wafers cut from the cone side, the central part, and the tail side of the crystals thus obtained, ring-shaped OSFs were generated in six out of nine crystals. Moreover, as a result of measurement of the B concentration in a crystal having being performed on the tail-side samples by the PL method, the B concentration was 1.46×10¹² to 2.97×10¹² atoms/cm³ (samples Nos. 1 to 9 in Table 1).

The results of the examples and the comparative example are shown in Table 1.

**[Table 1]**

| | Sample No. | B concentration (ppba) | Presence or absence of generation of OSF |
|---|---|---|---|
| Comparative Example | 1 | 2.26×10¹²atoms/cm³ | Present |
| | 2 | 1.56×10¹²atoms/cm³ | Present |
| | 3 | 1.46×10¹²atoms/cm³ | Present |
| | 4 | 2.52×10¹²atoms/cm³ | Present |
| | 5 | 1.86×10¹² atoms/cm³ | Present |
| | 6 | 1.56×10¹²atoms/cm³ | Present |
| | 7 | 1.46×10¹²atoms/cm³ | None |
| | 8 | 1.46×10¹²atoms/cm³ | None |
| | 9 | 2.97×10¹²atoms/cm³ | None |
| Example 1 | 10 | 5.73×10¹²atoms/cm³ | None |
| | 11 | 5.73×10¹²atoms/cm³ | None |
| | 12 | 4.07×10¹²atoms/cm³ | None |
| | 13 | 6.29×10¹²atoms/cm³ | None |
| | 14 | 4.43×10¹²atoms/cm³ | None |
| | 15 | 8.15×10¹²atoms/cm³ | None |
| | 16 | 5.08×10¹²atoms/cm³ | None |
| | 17 | 7.19×10¹²atoms/cm³ | None |
| Example 2 | 18 | 5.38×10¹²atoms/cm³ | None |
| | 19 | 8.05×10¹²atoms/cm³ | None |
| | 20 | 5.33×10¹²atoms/cm³ | None |
| | 21 | 3.92×10¹²atoms/cm³ | None |
| | 22 | 4.23×10¹²atoms/cm³ | None |
| | 23 | 3.72×10¹²atoms/cm³ | None |
| | 24 | 3.97×10¹²atoms/cm³ | None |
| | 25 | 4.07×10¹²atoms/cm³ | None |
| | 26 | 3.22×10¹²atoms/cm³ | None |
| | 27 | 3.45×10¹²atoms/cm³ | None |

As indicated in Table 1, in the comparative example (samples Nos. 1 to 9), doping with B was not performed, the B concentration in the crystal was less than 3×10¹² atoms/cm³, which was considered to be unavoidably mixed, and ring-shaped OSFs were generated in six out of nine crystals; on the other hand, in the examples (samples Nos. 10 to 27), as a result of performing doping with B, the B concentration in the single crystal became 3×10¹² atoms/cm³ or more, and ring-shaped OSFs were not generated in all of the 18 crystals.

As described above, with the existing method, it is clear that OSFs are generated with high frequency. On the other hand, with the method of the present invention, the generation of OSFs could be prevented, and it became clear that the method of present invention was highly effective.

Based on the above description, according to the method for producing an N-type silicon single crystal of the present invention, it can be said that the generation of OSFs can be prevented even when, in particular, the crystal has a large diameter of 8 inches (200 mm) or more and a high-quality FZ silicon single crystal can be produced with stability.

Moreover, since OSFs were not generated in all of the obtained silicon single crystals with a B concentration of 3×10¹² atoms/cm³ or more, it can be said that it has been proved that the generation of OSFs can be prevented more effectively when the B concentration in a crystal is 3×10¹² atoms/cm³ or more.

It is to be understood that the present invention is not limited in any way by the embodiment thereof described above. The above embodiment is merely an example, and anything that has substantially the same structure as the technical idea recited in the claims of the present invention and that offers similar workings and benefits falls within the technical scope of the present invention.

## Claims

1. A method for producing an N-type silicon single crystal with a diameter of 8 inches (200 mm) or more by the FZ method, wherein
the N-type silicon single crystal is produced by performing doping by using Ar-based PH₃ gas and Ar-based B₂H₆ gas as doping gas, and by feeding the Ar-based B₂H₆ gas in such a way that a B concentration in the N-type silicon single crystal to be produced becomes 3x10¹² atoms/cm³ or more.

2. The method for producing an N-type silicon single crystal according to claim 1, wherein
the doping by the Ar-based PH₃ gas and the Ar-based B₂H₆ gas is performed by mixing the Ar-based PH₃ gas and the Ar-based B₂H₆ gas and feeding the mixture of the gases from a nozzle for spraying doping gas, the nozzle provided near molten melt of an FZ single crystal production apparatus, or a doping gas jetting port provided below the molten melt.

3. The method for producing an N-type silicon single crystal according to claim 1, wherein
the doping by the Ar-based PH₃ gas and the Ar-based B₂H₆ gas is performed by feeding the Ar-based PH₃ gas from a nozzle for spraying doping gas, the nozzle provided near molten melt of an FZ single crystal production apparatus, and by feeding the Ar-based B₂H₆ gas from a doping gas jetting port provided below the molten melt.

## Patentansprüche

1. Verfahren zur Herstellung eines Silicium-Einkristalls vom N-Typ mit einem Durchmesser von 8 Inch (200 mm) oder darüber, mittels des FZ-Verfahrens, worin
der Silicium-Einkristall vom N-Typ hergestellt wird mittels Durchführung eines Dotierens durch Verwendung eines Ar-basierten PH₃-Gases und eines Ar-basierten B₂H₆-Gases als Dotierungsgas, und durch Einspeisen des Ar-basierten B₂H₆-Gases in einer solchen Weise, dass eine B-Konzentration in dem herzustellenden Silicium-Einkristall vom N-Typ 3x10¹² Atome/cm³ oder darüber wird.

2. Verfahren zur Herstellung eines Silicium-Einkristalls vom N-Typ gemäß Anspruch 1, worin das Dotieren durch das Ar-basierte PH₃-Gas und das Ar-basierte B₂H₆-Gas durchgeführt wird durch Vermischen des Ar-basierten PH₃-Gases und des Ar-basierten B₂H₆-Gases und Einspeisen der Mischung der Gase von einer Düse für das Sprühen von Dotierungsgas, wobei die Düse nahe der geschmolzenen Schmelze einer FZ-Einkristall-Herstellungsvorrichtung vorgesehen ist, oder ein Dotierungsgas-Sprühport unterhalb der geschmolzenen Schmelze vorgesehen ist.

3. Verfahren zur Herstellung eines Silicium-Einkristalls vom N-Typ gemäß Anspruch 1, worin das Dotieren durch das Ar-basierte PH₃-Gas und das Ar-basierte B₂H₆-Gas durchgeführt wird unter Einspeisung des Ar-basierten PH₃-Gases von einer Düse zum Sprühen von Dotierungsgas, wobei die Düse nahe der geschmolzenen Schmelze einer FZ-Einkristall-Herstellungsvorrichtung vorgesehen ist, und durch Einspeisen des Ar-basierten B₂H₆-Gases von einem Dotierungsgas-Sprühport, der unterhalb der geschmolzenen Schmelze vorgesehen ist.

## Revendications

1. Procédé de production d'un monocristal de silicium de type N d'un diamètre de 8 pouces (200 mm) ou plus par la méthode FZ, dans lequel
le monocristal de silicium de type N est produit en effectuant un dopage à l'aide de gaz PH₃ à base d'Ar et de gaz B₂H₆ à base d'Ar comme gaz dopant, et en alimentant le gaz B₂H₆ à base d'Ar de telle manière qu'une concentration en B dans le monocristal de silicium de type N à produire passe à 3 x 10¹² atomes/cm³ ou plus.

2. Procédé de production d'un monocristal de silicium de type N selon la revendication 1, dans lequel
le dopage par le gaz PH₃ à base d'Ar et le gaz B₂H₆ à base d'Ar est effectué en mélangeant le gaz PH₃ à base d'Ar et le gaz B₂H₆ à base d'Ar et en alimentant le mélange des gaz à partir d'une buse de pulvérisation de gaz dopant, la buse étant disposée à proximité de la masse en fusion d'un appareil de production de monocristaux FZ, ou d'un orifice de projection de gaz dopant disposé au-dessous de la masse en fusion.

3. Procédé de production d'un monocristal de silicium de type N selon la revendication 1, dans lequel
le dopage par le gaz PH₃ à base d'Ar et le gaz B₂H₆ à base d'Ar est effectué en alimentant le gaz PH₃ à base d'Ar à partir d'une buse de pulvérisation de gaz dopant, la buse étant disposée à proximité de la masse en fusion d'un appareil de production de monocristaux FZ, et en alimentant le gaz B₂H₆ à base d'Ar à partir d'un orifice de projection de gaz dopant disposé au-dessous de la masse en fusion.
